# EUROPÄISCHE PATENTSCHRIFT

(11) **EP 1 711 746 B1**
(45) Veröffentlichungstag und Bekanntmachung des Hinweises auf die Patenterteilung: **16.08.2017**
(21) Anmeldenummer: 05715207.6
(22) Anmeldetag: 25.01.2005
(51) Int. Cl.: F24C 7/08, H03K 17/975, H05B 3/74

(54) **BEDIENEINRICHTUNG FUR EIN ELEKTROGERAT MIT EINEM BEDIENFELD UND EINEM SENSORELEMENT DARUNTER**
OPERATING DEVICE FOR AN ELECTRICAL APPLIANCE HAVING A CONTROL PANEL AND SUBJACENT SENSOR ELEMENT
DISPOSITIF DE COMMANDE POUR UN APPAREIL ELECTRIQUE COMPRENANT UN TABLEAU ELECTRIQUE ET UN ELEMENT DE DETECTION

(30) Priorität: 02.02.2004 DE 102004005954
(43) Veröffentlichungstag der Anmeldung: 18.10.2006
(73) Patentinhaber: E.G.O. Elektro-Gerätebau GmbH, 75038 Oberderdingen (DE)
(72) Erfinder: BAIER, Martin, 76275 Ettlingen (DE)
(74) Vertreter: Patentanwälte Ruff, Wilhelm, Beier, Dauster & Partner mbB
(86) Internationale Anmeldenummer: PCT/EP2005/000705
(87) Internationale Veröffentlichungsnummer: WO 2005/073633

(56) Entgegenhaltungen:
- EP-A- 0 831 276
- DD-A1- 141 443
- DE-A1- 3 407 380
- DE-A1- 10 052 585
- DE-A1- 10 146 996
- DE-A1- 10 219 641
- DE-A1- 19 706 168
- DE-A1- 19 811 372
- DE-C1- 19 817 195
- DE-C1- 19 918 290
- US-A1- 2003 217 873

## Beschreibung

### Anwendungsgebiet und Stand der Technik

Die Erfindung betrifft eine Bedieneinrichtung für ein Elektrogerät, vorzugsweise ein Haushaltsgerät.

Es ist aus dem Stand der Technik bekannt, beispielsweise aus der DE-A-19645678 oder der DE-A-19811372, für ein Elektrogerät oder Haushaltsgerät eine Bedien-Blende vorzusehen, unter der an einer bestimmten Stelle, welche ein sogenanntes Bedien-Feld bildet, ein druckempfindliches Piezo-Element angeordnet ist. Wird auf die Abdeckung, welche beispielsweise aus dünnem Edelstahl oder Aluminium bestehen kann, gedrückt, so kann dieses Drücken durch das Piezo-Element als gewünschte Bedienung ausgewertet werden. Eine zugeordnete Auswertung oder Steuerung gibt ein Signal an das Elektrogerät. Als nachteilig wird hierbei angesehen, dass die Verwendung von Piezo-Elementen gewisse Nachteile mit sich bringt, insbesondere, weil diese teilweise mechanisch anfällig sind und nicht leicht in ein Gerät eingebaut werden können. Des weiteren müssen oftmals Sonderanfertigungen bzw. Sonderbauteile von Piezo-Elementen eingesetzt werden, was den Aufwand, insbesondere Kosten und kurzfristige Verfügbarkeit, weiter negativ beeinträchtigt. Der Einsatz anderer Sensorelemente wie kapazitiver oder optischer Sensorelemente weist den Nachteil auf, dass diese entweder derzeit noch nicht bzw. nur mit sehr großem Aufwand hinter metallischen Bedienblenden eingesetzt werden können oder für ein optisches System eine optische Durchlässigkeit unerlässlich ist.

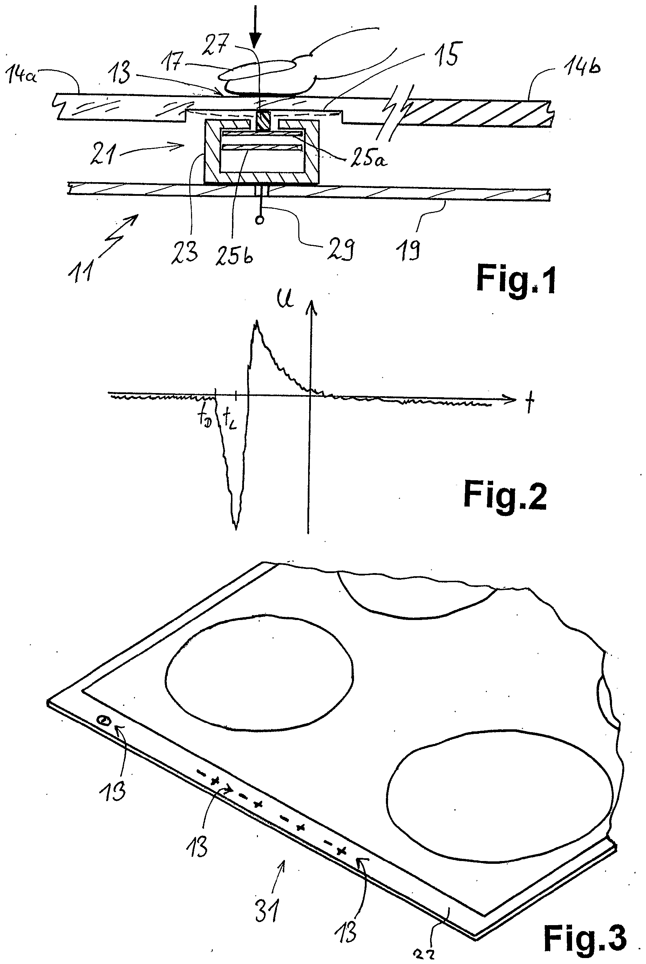

Die DD 141443 A zeigt eine Bedieneinrichtung mit mehreren Piezo-Elementen und Bedien-Feldern darüber. Sie zeigt in der Figur 3, dass eine solche Matrix von zwanzig Bedien-Feldern vorgesehen sein kann. Diese sind nicht geschlossen bzw. unterbrechungsfrei, da zwischen jeweils vier Tellerfedern 3 eine viereckige Fläche mit eingeschnittenen Ecken frei bleibt.

Die DE 10219641 A offenbart eine Kombination eines Lautsprechers mit einer Anzeige, die berührsensitiv ist, wobei die schallabstrahlende Fläche des Lautsprechers die berührungsempfindliche Anzeigefläche bildet. Um den Lautsprecher herum sind Sensoren in Form von Mikrofonen vorgesehen, die an der Art des abgestrahlten Schalls erkennen können, ob und vor allem wo eine Berührung an der Anzeige erfolgt ist.

Die DE 10146996 A zeigt eine Schaltung mit optoelektronischen Berührsensoren. Dabei sind sowohl Lichtsender als auch Lichtempfänger unter einer lichtdurchlässigen Abdeckung angeordnet. Das Licht geht jeweils durch diese hindurch und wird von einem aufgelegten Finger derart reflektiert, dass dessen Ort des Auflegens ermittelt werden kann.

Die US 2003/0217873 A1 offenbart eine Bedieneinrichtung für ein Elektrogerät mit einem großen Bedien-Bereich. Es geht dabei darum, akustische Signale durch beispielsweise Anklopfen oder Anschlagen auf den Bedien-Bereich zu erkennen und zu orten unabhängig von Störbeeinflussung. Dies wird mit Mikrofonen gemacht, die in den Ecken des Bedien-Bereichs angeordnet sind. Ein Niederfrequenzwandler ist an der Mitte der oberen Kante vorgesehen und soll ein Anschlagen am Bedien-Bereich erkennen. Da ein solches Anschlagen nicht als ortsabhängige Bedienung ausgewertet werden soll, benötigt man hier nur einen einzigen Sensor.

### Aufgabe und Lösung

Der Erfindung liegt die Aufgabe zugrunde, eine eingangs genannte Bedieneinrichtung zu schaffen, mit der die Nachteile des Standes der Technik vermieden werden können und insbesondere eine Bedieneinrichtung geschaffen und verwendet werden kann, die mit geringem herstellerseitigen Aufwand aufgebaut werden kann und möglichst aus Standardbauteilen besteht.

Diese Aufgabe wird gelöst durch eine Bedieneinrichtung mit den Merkmalen des Anspruchs 1. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß ist vorgesehen, dass als druckempfindliches Sensorelement eine Elektret-Mikrofonkapsel vorgesehen ist, welche vorteilhaft ein Standardbauteil ist, wobei eine relativ geringe Baugröße, insbesondere eine relativ geringe Dicke, erstrebenswert ist. Diese Elektret-Mikrofonkapsel wandelt die Bewegung des Bedien-Feldes, welches sich auf die Kapsel überträgt, in ein elektrisches Signal um. Dieses kann als Bedienung ausgewertet werden, wobei es möglich ist, gewisse Signalschwellen vorzusehen, was nachfolgend jedoch noch genauer erläutert werden wird.

Dadurch ist es möglich, als druckempfindliches Sensorelement ein üblicherweise verwendetes Bauteil, insbesondere ein Standard-Bauteil, zu verwenden. Derartige Mikrofonkapseln weisen den Vorteil auf, dass sie eine hohe Empfindlichkeit haben. Das bedeutet, dass bereits ein relativ geringer Bedienweg an der Membran, welche üblicherweise Schalldruck- oder Schallwellen auswertet, ausreicht für eine sichere Erkennung oder Unterscheidung. Des weiteren sind derartige Standard-Bauteile bereits fertig angeschlossen und verdrahtet erhältlich, was den Einsatz vereinfacht, insbesondere den Aufwand beim Zusammenbau und/oder Anschluss.

Das Bedien-Feld bildet einen Teil einer Abdeckung oder einer Blende, welche sich auch über einen größeren, insbesondere weitaus größeren, Bereich des Elektrogeräts erstrecken kann. Ein Rahmen eines Kochfeldes kann sie beispielsweise enthalten. Dabei sind das Bedien-Feld bzw. die Abdeckung oder die Blende geschlossen bzw. weisen keine Unterbrechungen auf. Insbesondere ist sie nach außen glatt bzw. eben. Durch eine derartige geschlossene Ausbildung ist beispielsweise ein ansprechendes Design sowie eine Widerstandsfähigkeit gegen Wasser oder dergleichen zu erreichen.

Es ist vorteilhaft, wenn das Bedien-Feld oder eine entsprechende Abdeckung oder Blende in einem Bereich über dem Sensorelement elastisch oder dünner ausgeführt ist als sonst. Dies soll bewirken, dass beispielsweise bei im übrigen relativ dicken Abdeckungen oder Blenden, welche auch eine mechanische Festigkeit bieten sollen und somit gerade ein Durchbiegen möglichst vermeiden sollen, im Bereich des Bedien-Feldes bzw. an den Sensorelementen eine gewisse Eindrückbarkeit ermöglicht wird. Derartige dünnere Ausführungen können beispielsweise durch Ausnehmungen oder Verdünnungen erreicht werden, welche vorteilhaft auf der Innen- oder Rückseite eines Bedien-Feldes angeordnet sein können.

Eine Möglichkeit zur Ausbildung eines Bedien-Feldes oder einer Blende bzw. Abdeckung ist es, sie elektrisch leitfähig zu machen bzw. aus dünnem Metall zu bilden. Hier können auch Metallfolien verwendet werden, welche insbesondere wegen ihrer Beständigkeit gegen mechanische Einwirkungen sowie Verschmutzung vorteilhaft verwendet werden können. Ein bevorzugtes Material ist beispielsweise Edelstahl oder Aluminium.

In weiterer Ausgestaltung der Erfindung ist es möglich, dass das Sensorelement über ein Kopplungselement, welches vorteilhaft elastisch ist, mit dem Bedien-Feld verbunden ist bzw. an dieses angekoppelt ist. Hier kann eine direkte schlüssige Kopplung vorgesehen sein, welche vorteilhaft an die Unterseite des Bedien-Feldes oder Rückseite führt. Die Elastizität kann als Schutz für das Sensorelement bzw. die gesamte Bedieneinrichtung vorgesehen sein derart, dass bei einer üblichen bestimmungsgemäßen Bedienungskraft das Kopplungselement nicht oder kaum zusammengedrückt wird, also im wesentlichen seine Form und vor allem wirksame Länge beibehält. Erst wenn die Bedienungskraft so stark ansteigt, dass sie die übliche bestimmungsgemäße Kraft weit übersteigt, beispielsweise um den Faktor 2 bis 4 oder mehr, kann sich das Kopplungselement eindrücken bzw. verkürzen. So kann ein Überdrücken und Beschädigen oder Zerstören des Sensorelements verhindert werden.

Als Kopplungselement bieten sich grundsätzlich viele elastische Bauteile an. Besonders bevorzugt wird ein Elastomer verwendet. Dieses kann direkt mit der Membran der Elektret-Mikrofonkapsel verbunden sein.

In weiterer Ausgestaltung der Erfindung kann ein Träger unterhalb des Bedien-Feldes vorgesehen sein. Auf diesem ist die Elektret-Mikrofonkapsel angeordnet und vorteilhaft gegenüber dem Bedien-Feld so abgestützt, dass eine Bedienungskraft zwar auf die Mikrofonkapsel einwirkt, nicht jedoch den Träger durchbiegt. Der Träger ist vorteilhaft eine Leiterplatte. Eine elektrische Kontaktierung bzw. Zuleitungen, welche für die Ansteuerung oder Auswertung vorgesehen sind, können daran angeordnet sein. Bei einer Leiterplatte sind dies vorteilhaft entsprechende Leiterbahnen. Des weiteren kann der Träger bzw. die Leiterplatte eine Steuerung oder dergleichen aufweisen, welche für die Mikrofonkapsel vorgesehen ist, beispielsweise auch für das gesamte Elektrogerät.

Bei der Erfindung ist an der Bedieneinrichtung nicht nur ein einziges Bedien-Feld, sondern es sind mehrere Bedien-Felder für verschiedene Funktionen oder separate Funktionseinheiten des Elektrogerätes vorgesehen. Diese Bedien-Felder sind gruppenweise oder nebeneinander in einem Bedien-Bereich angeordnet, welcher zur besonderen Kennzeichnung entsprechend gestaltet sein kann. Dabei ist eine einstückige und durchgängige Abdeckung vorgesehen, in welcher die Bedien-Felder vorgesehen sind bzw. welche unter anderem den Bedien-Bereich bilden. Dies weist den Vorteil auf, dass der Aufwand geringer gehalten wird und vor allem auch sichergestellt werden kann, dass die Abdeckung wasserfest ist und dergleichen. Des weiteren ist es vorteilhaft möglich, eine solche Abdeckung als von den Mikrofonkapseln separates und leicht abnehmbares Teil auszubilden. Dies bedeutet, dass einerseits, insbesondere auf einem vorbeschriebenen Träger, eine oder mehrere Elektret-Mikrofonkapseln samt Ansteuerung und Auswertung aufgebaut sein können. Darauf kann dann eine Abdeckung aufgesetzt werden, welche in Varianten unterschiedlich gestaltet werden kann, je nach Design-Vorgaben verschiedener Hersteller oder Verwendungszweck. Dies ist insbesondere bei Abdeckungen aus Metall oder dergleichen von Vorteil. Alternativ ist es möglich, eine Elektret-Mikrofonkapsel an der Abdeckung selber zu befestigen bzw. daraus eine Art Baueinheit zu bilden. Die Seite mit der Membran, auf welche der Bedienungsdruck einwirken soll, kann dann auch auf der von der Abdeckung weg weisenden Seite vorgesehen sein. Somit wird also die Mikrofonkapsel selber gegen einen Träger oder dergleichen gedrückt bei der Bedienung. Die Anbringung an einer Abdeckung bedeutet jedoch einen in der Regel erhöhten Anschlussaufwand für die Elektret-Mikrofonkapseln. Eine Vorkonfektionierung mit fertigem Anschluss an eine Steuerung oder Auswertung ist dann nicht mehr oder nur dann möglich, wenn Steuerung oder Auswertung an der Abdeckung angeordnet sind.

Als beispielhafte und vorteilhafte Dimensionierungen kann vorgesehen sein, dass das Bedien-Feld lediglich ein kleines Stück eingedrückt wird zur Bedienung bzw. zur Erkennung durch die Elektret-Mikrofonkapsel. Eine Durchbiegung kann maximal 100 µm betragen, vorteilhaft 1 µm bis 10 µm. Das dadurch ausgelöste Signal an der Mikrofonkapsel kann als eine Art Signalwert oder Schwellenwert angesehen werden. Erst wenn dieses Signal erreicht oder überschritten wird, gilt es als gewollte und bestimmungsgemäße Bedienung, welche dann zur entsprechenden Auslösung als Bedienvorgang führt. Ein derartiger Bedienweg ist für einen Bediener beinahe nicht erfassbar, was jedoch durchaus gewünscht sein kann, da sich dadurch das Bedienverhalten wie bei beispielsweise optischen oder kapazitiven Berührungsschalten ergibt, ohne jedoch deren eingangs genannte Nachteile in Kauf nehmen zu müssen. Als bestimmungsgemäße oder vorgesehene Bedienungskraft können beispielsweise wenige Newton vorgesehen sein, welche bei entsprechend ausgebildeter Abdeckung oder Bedien-Feld zu der vorgenannten Durchbiegung führen können.

Bei einem bestimmungsgemäßen Verfahren zur Auswertung der Bedieneinrichtung kann vorgesehen sein, dass durch Drücken auf den Bedien-Bereich zuerst die Elektret-Mikrofonkapsel bzw. ihre Membran eingedrückt wird. Nach dem Loslassen stellt sich diese zurück. Diese Vorgänge lösen jeweils Signale aus bzw. bilden einen Signalverlauf, der vom grundsätzlichen Verlauf charakteristisch ist. Diese Signale bzw. der Signalverlauf werden nur dann als Bedienung angesehen, wenn er in vorgegebenen Grenzen liegt. Insbesondere ist es bei einer einfachen Ausgestaltung möglich, nach dem Erreichen des maximalen notwendigen Signals beim Eindrücken für eine bestimmte Zeit, beispielsweise mehr als eine halbe oder eine Sekunde, dieses bereits als Bedienung zu werten.

Bei einer anderen Ausbildung, welche insbesondere ein anderes Bedienungsverhalten ergeben soll sowie eine sicherere Bedienung, kann vorgesehen sein, dass das Signal des Zurückstellens abgewartet wird. Es muss ein bestimmter zeitlicher Abstand zwischen dem Signal des Eindrückens und demjenigen des Zurückstellens liegen. Dieser sollte weniger als 5 Sekunden betragen, vorteilhaft weniger als 2 Sekunden. Dies bedeutet, wenn ein Bediener für eine gewünschte Bedienung auf das Bedien-Feld drückt und instinktiv bzw. übungsgemäß gleich oder kurz danach wieder loslässt, wird dies als Bedienungsvorgang ausgewertet. Legt er jedoch aus Versehen einen etwas schwereren Gegenstand, wie beispielsweise einen Kochtopf bei einem Kochfeld, auf dem Bedien-Bereich ab, und verbleibt dieser für eine längere Zeit darauf, so wird dies erkannt und eben keine Bedienung ausgewertet.

Vorteilhaft werden Bedieneinrichtung und Verfahren für ein Elektrohaushaltsgerät wie beispielsweise ein Kochfeld, einen Backofen oder sogenannte Geräte der Weißwaren-Industrie verwendet. Dies sind ansonsten auch noch Waschmaschinen, Trockner oder Spülmaschinen sowie Mikrowellen oder dergleichen.

### Kurzbeschreibung der Zeichnungen

Ausführungsbeispiele der Erfindung sind in den Zeichnungen schematisch dargestellt und werden im folgenden näher erläutert. In den Zeichnungen zeigen:
- Fig. 1: einen Schnitt durch eine erfindungsgemäße Bedieneinrichtung, wobei zwei verschiedene Materialien für Bedien-Felder dargestellt sind
- Fig. 2: ein Diagramm der Signalspannung über der Zeit bei einem Bedienungsvorgang und
- Fig. 3: eine Schrägansicht eines Kochfeldes, bei dem im Rahmen eine Bedieneinrichtung ähnlich Fig. 1 integriert ist.

### Detaillierte Beschreibung der Ausführungsbeispiele

In Fig. 1 ist eine Bedieneinrichtung 11 im Schnitt dargestellt, welche beispielsweise für ein Kochfeld mit einer flächigen Abdeckung gedacht ist. Es ist ein Bedien-Feld 13 vorgesehen in einer Platte, welche im linken Bereich als Glaskeramikplatte 14a dargestellt ist. Im rechten Bereich soll veranschaulicht werden, inwiefern sie auch eine Metallplatte 14b sein kann. Unter dem Bedien-Feld 13 ist ein dünnerer Bereich 15 ausgebildet, welcher im wesentlichen mit der Ausdehnung des Bedien-Feldes übereinstimmen kann. Zur Kennzeichnung können an der Oberseite Beschriftungen oder dergleichen vorgesehen sein. Ebenso kann der dünnere Bereich 15 an der Oberseite des Bedien-Feldes 13 dem Bediener zugewandt vorgesehen sein und dadurch eine Führung für den Bediener bilden. Es ist dargestellt, wie ein Finger 17 eines Bedieners auf das Bedien-Feld 13 gelegt ist. Wird ein gewisser Bedien-Druck ausgeübt, welcher zuvor beschrieben worden ist, so biegt sich die Abdeckung 14 im dünneren Bereich 15 bzw. das Bedien-Feld 13 nach unten durch. Dies ist durch die nach unten gewölbte Strichlierung angedeutet.

Unterhalb der Platte 14 bzw. unterhalb des Bedien-Feldes 13 ist eine Elektret-Mikrofonkapsel 21 auf einem Träger 19 angeordnet. Die Mikrofonkapsel 21 besteht aus einem Gehäuse 23, welches die Membran 25 enthält wie dargestellt. Die Mikrofonkapsel 21 bzw. die Membran 25 ist mittels eines Elastomerteils 27, welches beispielsweise zylinderartig sein kann, mit der Unterseite des dünnen Bereichs 15 durch direktes Anliegen gekoppelt. Eine Bewegung des dünneren Bereichs 15 wird somit direkt an die Membran 25 übertragen. Des weiteren weist die Mikrofonkapsel 21 einen elektrischen Anschluss 29 nach außen auf. Ist der Träger 19 beispielsweise als Leiterplatte ausgebildet, so können dies auch aufgedruckte Leiterbahnen sein.

Das Elastomerteil 27 ragt dabei durch eine Öffnung in der Oberseite des Gehäuses 23. Diese Öffnung kann gleichzeitig als eine gewisse Führung für das Elastomerteil 27 dienen, wobei dessen Bewegbarkeit möglichst nicht eingeschränkt werden sollte.

Der dünnere Bereich 15 in der Abdeckung 14 kann zwar vorteilhaft, muss jedoch nicht vorgesehen sein. Dies hängt vor allem von der Auswahl des Materials für das Bedien-Feld 13 bzw. für die Abdeckung 14 ab. Handelt es sich, wie dargestellt, um relativ steife bzw. feste Materialien, wie Metall 14b oder Glaskeramik 14a, so ist dies von Vorteil, da dadurch eine gewisse Durchbiegung bei vorgesehenem Bedien-Druck erzielt werden kann.

In Fig. 3 ist ein Kochfeld 31 dargestellt, insbesondere ein sogenanntes Glaskeramik-Kochfeld. Dieses weist auf an sich übliche Art einen umlaufenden Kochfeld-Rahmen 33 auf, der an seiner linken unteren Seite als zu einem Bediener hin weisende Vorderseite ausgebildet ist. Der Rahmen 33 weist verschiedene Bedien-Felder 13 auf, und zwar ganz links in Form eines EIN-/AUS Schalters sowie wie im Mittenbereich als Schalter zur Leistungseinstellung der einzelnen Kochstellen, welche kreisförmig schematisch dargestellt sind. Durch Druck auf die Bedien-Felder 13 kann die jeweils zugeordnete Funktion ausgelöst werden. Vom Aufbau her befindet sich unter dem Kochfeld-Rahmen 33 eine Bedieneinrichtung ähnlich derjenigen aus der Fig. 1. Dabei kann die Oberfläche des Kochfeld-Rahmens 33 bzw. er selber durchgängig aus einer Metallschicht oder Metallplatte bzw. Metallfolie gebildet sein, welche der Abdeckung 14 aus Fig. 1 entspricht. Da nur unterhalb der Bedien-Felder 13 die Mikrofonkapsel gemäß Fig. 1 vorzusehen ist, kann das Metall im sonstigen Bereich des Kochfeld-Rahmens 33 sozusagen massiv unterfüttert sein.

Alternativ kann der Kochfeld-Rahmen aus einem gegebenenfalls mehrere mm starken Flachmaterial bestehen, welches metallisch oder anders ausgebildet sein kann. Dieses ist beispielsweise im Bereich der Bedien-Felder 13 oder einer dazugehörigen Bedieneinrichtung von unten her so ausgedünnt, dass in diesen ausgedünnten Bereichen die Mikrofonkapsel 21 gemäß Fig. 1 untergebracht werden kann. Als Alternative zu einer Ausdünnung einer dickeren Metallschicht von unten kann auch eine Ausdünnung von oben vorgesehen sein. In diesem Fall könnte eine dadurch entstehende Mulde als Strukturierung für ein punktgenaues Anlegen eines Fingers oder dergleichen verwendet werden.

### Funktion

Durch das Auflegen des Fingers 17 auf das Bedien-Feld 13 mit einem gewissen Druck, welcher im oben genannten Maß liegen sollte, wird das Bedien-Feld 13 bzw. der dünnere Bereich 15 nach unten durchgebogen. Diese Durchbiegung bzw. dieser Hub kann in einem Bereich von wenigen µ liegen, beispielsweise bei einer Bedien-Kraft von ca. 2 N 2 µm bis 10 µm betragen. Die Elektret-Mikrofonkapsel wandelt selbst eine solche geringe Bewegung in ein elektrisches Signal um, wie es in Fig. 2 beispielhaft dargestellt ist.

In der vorliegenden Erfindung dient die Mikrofonkapsel 21 nicht dazu, Schalldruck in eine Bewegung und somit ein elektrisches Signal umzusetzen. Vielmehr wird eine mechanische Bewegung, welche über die Ankopplung mittels des Elastomerteils 27 an die Unterseite des Bedien-Feldes 13 erfolgt, direkt in ein elektrisches Signal umgewandelt. Das Elastomer 27 dient dabei zum einen dazu, mechanische Toleranzen bei dem Abstand zwischen Membran 25 und Unterseite des Bedien-Feldes 13 auszugleichen. Des weiteren kann es eine Art Überdrückungsschutz darstellen, wie vorstehend erläutert worden ist.

Aus dem Diagramm in Fig. 2 ist zu ersehen, wie sich die Signalspannung U der Mikrofonkapsel 21 im zeitlichen Verlauf beim Betätigen ändert. Zum Zeitpunkt t_{D} wird der Finger 17 auf das Bedien-Feld 13 aufgelegt bzw. es erfolgt das Drücken. Dieses bewirkt den Verlauf im negativen Bereich. Zum Zeitpunkt t_{L} wird der Finger 17 weggenommen, so dass sich der dünnere Bereich 15 bzw. das Bedien-Feld 13 wieder nach oben in die Ursprungslage zurückbewegt und ebenso die Membran 25 wieder nach oben bewegen kann. Dadurch wechselt die Signalkurve in den positiven Bereich, um dann schließlich wieder umzukippen und auf den ursprünglichen niedrigen Spannungswert zu gehen.

Aus diesem für einen Bedien-Vorgang typischen Kurvenverlauf kann auf eine gewünschte Bedienung geschlossen werden. Je nach gewünschter Anwendung bzw. Auswertungsverfahren für die Bedienung kann entweder bereits das Drücken oder das Loslassen als gewünschter Bedienungszeitpunkt angesehen werden. Ist eine besonders schnelle Reaktion auf einen Bedienvorgang gewünscht, so kann beim Drücken, also während des Abfallens der Signalkurve, ab einem bestimmten Wert, welcher einem bestimmten Bedienweg entspricht, ein Bedienvorgang als solcher erkannt und eine Funktion ausgelöst werden. Sollen dagegen bestimmte ungewünschte oder fehlerhafte Betätigungen, beispielsweise durch aufgelegte Gegenstände oder unbeabsichtigtes Wischen über ein Bedien-Feld ausgeschlossen werden, so empfiehlt es sich, den Zeitpunkt des Loslassens abzuwarten. Dieser muss in einem bestimmten zeitlichen Fenster zu dem Zeitpunkt des Drückens liegen, beispielsweise ca. eine Sekunde. Diese verschiedenen Verfahren können in einer zugeordneten Auswertung bzw. Steuerung hinterlegt sein und so durchgeführt werden.

## Patentansprüche

1. Bedieneinrichtung (11) für ein Elektrogerät (31), vorzugsweise ein Haushaltsgerät, umfassend:
- eine einstückige und durchgängige Abdeckung (14) und
- mehrere formveränderliche oder elastische Bedien-Felder (13) mit jeweils einem druckempfindlichen Sensorelement (21) darunter angeordnet,
wobei die Bedien-Felder (13) in einem Bedien-Bereich angeordnet sind und die Bedien-Felder als Teil der Abdeckung (14) geschlossen bzw. unterbrechungsfrei sind, wobei jeweils die Bedien-Felder bzw. der Bedien-Bereich von der einstückigen und durchgängigen Abdeckung (14) gebildet werden, wobei die Bedienung durch Drücken auf eines der Bedien-Felder (13) erfolgt und das Sensorelement die Bewegung des Bedien-Feldes in ein als Bedienung auswertbares elektrisches Signal wandelt,
**dadurch gekennzeichnet, dass** das Sensorelement (21) eine Elektret-Mikrofonkapsel aufweist und nur unterhalb und unter jedem der Bedien-Felder (13) Elektret-Mikrofonkapseln (21) vorgesehen sind.

2. Bedieneinrichtung nach Anspruch 1, **dadurch gekennzeichnet, dass** das Bedien-Feld oder die Abdeckung bzw. die Blende im Bereich über dem Sensorelement (21) elastischer oder dünner ausgeführt ist als im übrigen Bereich.

3. Bedieneinrichtung nach einem der vorhergehenden Ansprüche, **dadurch gekennzeichnet, dass** das Bedien-Feld (13) durchgängig elektrisch leitfähig ist oder aus dünnem Metall wie einer Metallfolie oder dergleichen besteht, vorzugsweise aus Edelstahl.

4. Bedieneinrichtung nach einem der vorhergehenden Ansprüche, **dadurch gekennzeichnet, dass** das Sensorelement (21) über ein elastisches Kopplungselement (27) mit dem Bedien-Feld verbunden ist, insbesondere als direkte formschlüssige Kopplung an dessen Unterseite, wobei vorzugsweise die Elastizität derart ist, dass bei einer üblichen bestimmungsgemäßen Bedienungskraft das Kopplungselement nicht oder kaum zusammengedrückt wird und erst bei einer die übliche bestimmungsgemäße Bedienungskraft weit übersteigenden Bedienungskraft zusammengedrückt wird.

5. Bedieneinrichtung nach Anspruch 4, **dadurch gekennzeichnet, dass** das Kopplungselement (27) ein Elastomer ist, das direkt mit der Membran (25) der Elektret-Mikrofonkapsel (21) verbunden ist.

6. Bedieneinrichtung nach einem der vorhergehenden Ansprüche, **gekennzeichnet durch** einen Träger unterhalb des Bedien-Feldes, vorzugsweise eine Leiterplatte (19), auf welchem die Elektret-Mikrofonkapsel (21) angeordnet ist, wobei insbesondere der Träger die elektrische Kontaktierung und/oder eine Ansteuerung bzw. Auswertung für die Elektret-Mikrofonkapsel oder die Bedieneinrichtung (11) aufweist.

7. Bedieneinrichtung nach einem der vorhergehenden Ansprüche, **dadurch gekennzeichnet, dass** ein elektrisches Signal der Elektret-Mikrofonkapsel (21) bei einer Durchbiegung des Bedien-Feldes (13) bzw. der Membran (25) der Elektret-Mikrofonkapsel von 1 - 100 µm, vorzugsweise 1 - 10 µm, eine Bedienung ist.

## Claims

1. Operating device (11) for an electrical appliance (31), preferably a domestic appliance, comprising:
- a one-piece and continuous cover (14) and
- a plurality of shape-variable or elastic operating fields (13), each with a pressure-sensitive sensor element (21) disposed below it,
wherein the operating fields (13) are arranged in an operating area and the operating fields are closed or uninterrupted as part of the cover (14), wherein each of the operating fields and the operating area, respectively, are formed by the one-piece, continuous cover (14), wherein operation is by pressing on one of the operating fields (13) and the sensor element converts the movement of the operating field into an electrical signal evaluatable as an operation,
**characterized in that** the sensor element (21) has an electret microphone capsule, and electret microphone capsules (21) are provided only below and under each of the operating fields (13).

2. Operating device according to claim 1, **characterized in that** the operating field or the cover or the panel are made more elastic or thinner in the area above the sensor element (21) than in the remaining area.

3. Operating device according to any of the preceding claims, **characterized in that** the operating field (13) is electrically conductive throughout or made of a thin metal such as a metallic foil or the like, preferably of high-grade steel.

4. Operating device according to any of the preceding claims, **characterized in that** the sensor element (21) is connected by an elastic coupling element (27) to the operating field, in particular as a direct, positive coupling to the underside thereof, wherein preferably the elasticity is such that in the case of a standard, prescribed operating force the coupling element is not or is only scarcely compressed and only in the case of an operating force exceeding by far the standard, prescribed operating force is it compressed.

5. Operating device according to claim 4, **characterized in that** the coupling element (27) is an elastomer directly connected to the diaphragm (25) of the electret microphone capsule (21).

6. Operating device according to any of the preceding claims, **characterized by** a support below the operating field, preferably a circuit board (19) on which is placed the electret microphone capsule (21), wherein in particular the support has the electrical contacting and/or a control/evaluation for the electret microphone capsule or the operating device (11).

7. Operating device according to any of the preceding claims, **characterized in that** an electrical signal of the electret microphone capsule (21) is an operation in the case of a deflection of the operating field (13) or the diaphragm (25) of the electret microphone capsule of 1 to 100 µm, preferably 1 to 10 µm.

## Revendications

1. Dispositif de commande (11) pour un appareil électrique (31), de préférence un appareil électroménager, comprenant :
- un recouvrement (14) d'un seul tenant et continu et
- plusieurs champs de commande (13) de forme modifiable ou élastiques avec respectivement un élément de capteur (21) sensible à la pression qui est disposé au-dessous, les champs de commande (13) étant situés dans une zone de commande, et les champs de commande étant, en tant que partie du recouvrement (14), fermés ou respectivement étant dépourvus d'interruptions, les champs de commande ou respectivement la zone de commande étant formés par le recouvrement (14) d'un seul tenant et continu, la commande s'effectuant par la pression sur un des champs de commande (13), et l'élément de capteur convertissant le mouvement du champ de commande en un signal électrique pouvant être analysé en tant que commande,
**caractérisé en ce que** l'élément de capteur (21) présente une capsule de microphone électret et **en ce que** des capsules de microphone électret sont prévues uniquement au-dessous et sous chacun des champs de commande (13).

2. Dispositif de commande selon la revendication 1, **caractérisé en ce que** le champ de commande ou le recouvrement ou respectivement le bandeau est réalisé de façon plus élastique ou plus mince dans la zone au-dessus de l'élément de capteur (21) que dans le reste de la zone.

3. Dispositif de commande selon l'une des revendications précédentes, **caractérisé en ce que** le champ de commande (13) est électriquement conducteur de façon continue ou se compose d'un métal mince comme une feuille métallique ou similaire, de préférence en acier fin.

4. Dispositif de commande selon l'une des revendications précédentes, **caractérisé en ce que** l'élément de capteur (21) est raccordé au champ de commande par le biais d'un élément d'accouplement (27) élastique, en particulier en tant qu'accouplement par liaison de forme directe sur son côté inférieur, l'élasticité étant de préférence telle que, pour une force de commande conforme à l'utilisation usuelle, l'élément d'accouplement n'est pas comprimé ou est à peine comprimé et n'est comprimé que pour une force de commande dépassant largement la force de commande conforme à l'utilisation usuelle.

5. Dispositif de commande selon la revendication 4, **caractérisé en ce que** l'élément d'accouplement (27) est un élastomère qui est raccordé directement à la membrane (25) de la capsule de microphone électret (21).

6. Dispositif de commande selon l'une des revendications précédentes, **caractérisé par** un support au-dessous du champ de commande, de préférence une plaque de circuit (19) sur laquelle est disposée la capsule de microphone électret (21), en particulier le support présentant la mise en contact électrique et/ou un pilotage ou respectivement une analyse pour la capsule de microphone électret ou le dispositif de commande (11).

7. Dispositif de commande selon l'une des revendications précédentes, **caractérisé en ce qu'**un signal électrique de la capsule de microphone électret (21) est une commande en présence d'une flexion de 1 - 100 µm, de préférence de 1 - 10 µm, du champ de commande (13) ou respectivement de la membrane (25) de la capsule de microphone électret.
